# EUROPEAN PATENT SPECIFICATION

(11) **EP 4 230 761 B1**
(45) Date of publication and mention of the grant of the patent: **12.06.2024**
(21) Application number: 22195507.3
(22) Date of filing: 14.09.2022
(51) Int. Cl.: C23C 14/00, C23C 14/08, C23C 14/34

(54) **A METHOD FOR REACTIVE MAGNETRON SPUTTER DEPOSITION OF GALLIUM OXIDE THIN FILMS**
VERFAHREN ZUR REAKTIVEN MAGNETRON-SPUTTERBESCHICHTUNG VON GALLIUMOXID-DÜNNSCHICHTEN
PROCÉDÉ DE DÉPÔT RÉACTIF PAR PULVÉRISATION MAGNÉTRON DE COUCHES MINCES D'OXYDE DE GALLIUM

(30) Priority: 28.12.2021 LV 210105
(43) Date of publication of application: 23.08.2023
(73) Proprietor: Latvijas Universitates Cietvielu fizikas instituts, 1063 Riga (LV)
(72) Inventor: AZENS, Andris, 5120 Plavinas, Aizkraukles nov. (LV); ZUBKINS, Martins, 1006 Riga (LV); BUTANOVS, Edgars, 1026 Riga (LV); PURANS, Juris, 1010 Riga (LV)
(74) Representative: Fortuna, Jevgenijs

(56) References cited:
- US-A1- 2015 060 262

## Description

### Field of the Invention

This invention relates to a method of reactive magnetron sputtering deposition of Ga₂O₃ thin films from a metallic target.

### Background Art

Ga₂O₃ can crystallize in five different phases. While the most stable and technologically relevant is the monoclinic β phase [1], there is an increasing interest in the other phases [2,3] and amorphous Ga₂O₃ coatings [4] as well.

The properties of technological importance include transparency in the UV part of the spectrum due to its wide band gap of approximately 5 eV, decent carrier mobility (~100 cm²/Vs), high breakdown field (8 MV/cm), and high thermal and chemical stability. Practical applications include high-voltage transistors, high-power Schottky diodes, high-temperature chemical sensors, and transparent conductive oxides in devices requiring high transmittance in the short wavelength part of the spectrum [1,5].

Furthermore, use of β-Ga₂O₃ thin films as TCOs in ferroelectric solar cells was reported, and a record-breaking bulk photovoltaic effect with white light illumination was achieved due to the solar blindness of the electrode [6].

The known methods of Ga₂O₃ thin film deposition include MOCVD [7], ALD [8], PLD [9], e-beam evaporation [4], aqueous solution deposition [10], and RF magnetron sputtering from ceramic Ga₂O₃ targets [11,12-17]. Apart from the sputtering conditions, the deposition rate of sputter-deposited films has been reported to depend on the substrate temperature as well. The films on 800°C sapphire substrates were deposited at 1 nm/min [12-15], in sharp contrast with the rate of 15 - 22 nm/min for films deposited onto unheated glass substrates [11]. A deposition rate decreases from approximately 20 to less than 10 nm/min upon silicon substrate temperature increase from 100 to 600 °C was reported in [16].

The subject of the invention is gallium oxide thin films coatings deposited by reactive DC magnetron sputtering from metallic gallium target. The deposition rate - up to 41 nm/min at room temperature on quartz and 5 nm/min at 800 °C on sapphire - is higher than the literature data for RF sputtering (22 and 1 nm/min, respectively).

Amorphous and crystalline films have been deposited depending on the substrate temperature. At room to 500 °C substrate temperature a feature in XRD spectrum is present that may be indicative of the presence of small size crystallites of β -Ga₂O₃ in a predominantly amorphous film. At 700 °C temperature an up, β -Ga₂O₃ of single orientation was detected on sapphire, a mix of different orientations detected on quartz. The film structure dependence on the temperature is consistent with the literature data for other methods of deposition.

US2015/0060262 [17] describes a sputtering system with a liquid target (which can be gallium) depositing on a second rotatable solid target (which can be indium), the two materials being co-sputtered on a substrate.

### Summary of the Invention

Unless specific thickness values are provided, the term "thin film" in this description refers to a surface coating with the thickness in the range from 50 to 2500 nm.

The goal of the invention is to provide a method for deposition of gallium oxide on a substrate. The set goal is reached by the proposed method for deposition of gallium oxide on a substrate inside a vacuum chamber by reactive direct current magnetron sputtering device, wherein the method comprises the following steps: (i) placing metallic gallium pellets into a stain less steel container; (ii) heating the target container for the pellets to melt and form a uniform layer prior to mounting to the magnetron, to be the target in a liquid state during the sputtering; (iii) positioning the target in a vacuum chamber with the to serve as the source of sputtered particles; (iv) sputter-depositing an oxide film by reactive magnetron sputtering in argon/oxygen atmosphere; the base pressure in a turbomolecular pumped chamber preferably from 10⁻⁷ to 10⁻⁵ Torr and the process pressure preferably from 1.0 to 15.0 mTorr;
the front surface of the target container is precoated by an adhesion promoting layer wherein the adhesion-promoting layer is a layer of SiO₂ or carbon.

According to another embodiment the Oxygen flow during the sputtering is controlled by Plasma optical emission spectroscopy keeping the intensity of gallium 417,2 nm emission line constant at the level ensuring the deposition of an optically transparent film onto the substrate.

The melting temperature of metallic gallium is 29,8 °C.

The adhesion promoting layer allows a continuous layer of gallium to form and to withstand repeated deposition cycles without exposing the container base to sputtering.
According to yet another embodiment the front surface of the target container is precoated by a thin adhesion promoting layer of SiO₂. Since SiO₂ is electrically insulating, the electrical contact between the target container and the Gallium target is provided by a set of erosion-zone-shaped lines etched through the SiO₂ layer.

According to yet another embodiment the substrate is quartz or c-sapphire with the substrate temperature varied between room, i.e., no intentional heating provided, and 800 °C.

According to yet another embodiment the deposition rate for optically transparent films is up to 41 nm/min at room temperature on quartz and 5 nm/min at 800 °C on sapphire.

The time of the deposition is selected so to achieve the necessary thickness of the deposited film.

### Brief Description of Drawings

Fig. 1 - general representation of an embodiment of the stainless-steel container used for liquid Gallium target sputtering.

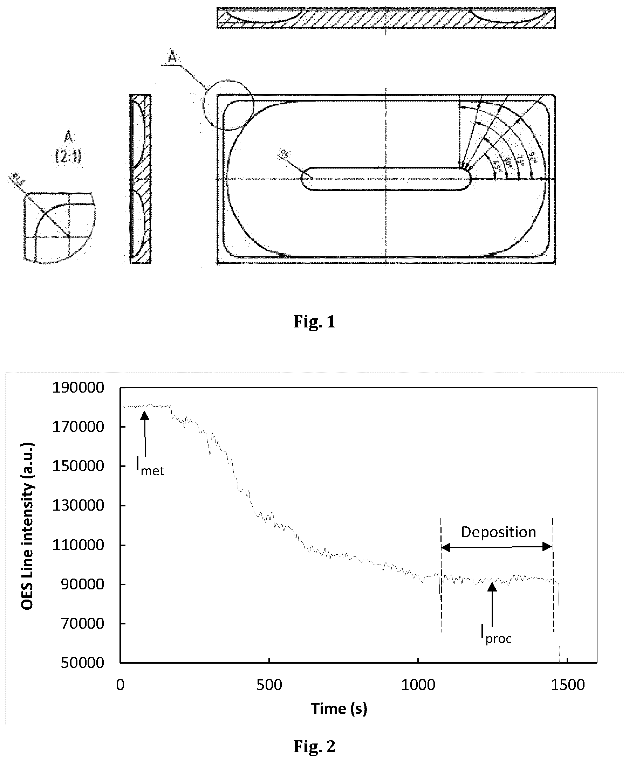

Fig. 2 - Example of a deposition run controlled by optical emission spectroscopy: Gallium 417,2 nm emission line intensity controlled by a PID loop adjusting the Oxygen flow. The run is started by sputtering in Argon, the line intensity denoted Iₘₑₜ. Oxygen is added and the flow increased until the line intensity reaches the level chosen for the deposition. The process is put into PID (proportional-integral-derivative) control mode keeping the line intensity constant, the shutter is open and the film is deposited onto the substrate surface. The line intensity during the deposition is denoted I_{proc}.
Fig. 3 - Film deposition rate as a function of normalized Ga 417,2 nm emission line intensity I_{proc}/Iₘₑₜ upon OES controlled sputtering from metallic Gallium target in Argon/Oxygen atmosphere at 100 (blue symbols), 150 (green symbols), 200 (black symbols) and 250 (red symbols) Watt power and the substrate kept at room (squares), 600°C (triangles), 700°c (diamonds) and 800°c (circles) temperature for films deposited onto quartz (open symbols) and sapphire (full symbols) substrates.
Fig. 4 - XRD patterns of Ga₂O₃ films deposited on quartz substrates at different temperatures. The films are amorphous at room temperature start to crystallize into β - Ga₂O₃ phase at 500°C. The amorphous films can be crystallized by annealing.

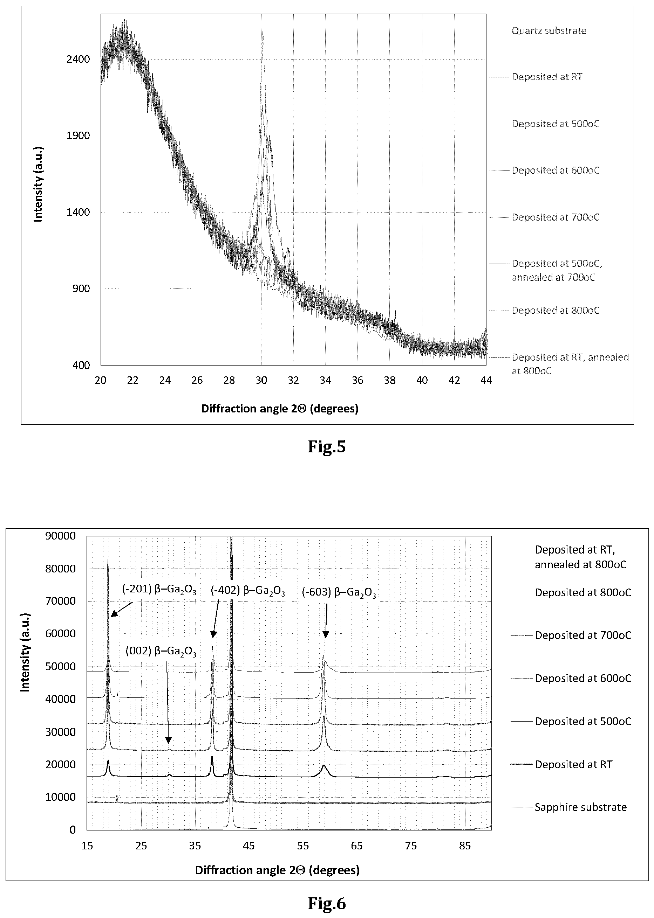

Fig. 5 - XRD patterns of Ga₂O₃ coatings on quartz substrates, indicating the presence of small size crystallites of β-Ga₂O₃ in the films deposited t room temperature.
Fig. 6 - XRD patterns of Ga₂O₃ films deposited on sapphire substrates at different temperatures. The films are amorphous at room temperature, start to crystallize into β - Ga₂O₃ phase at 500°C. The amorphous films can be crystallized by annealing.

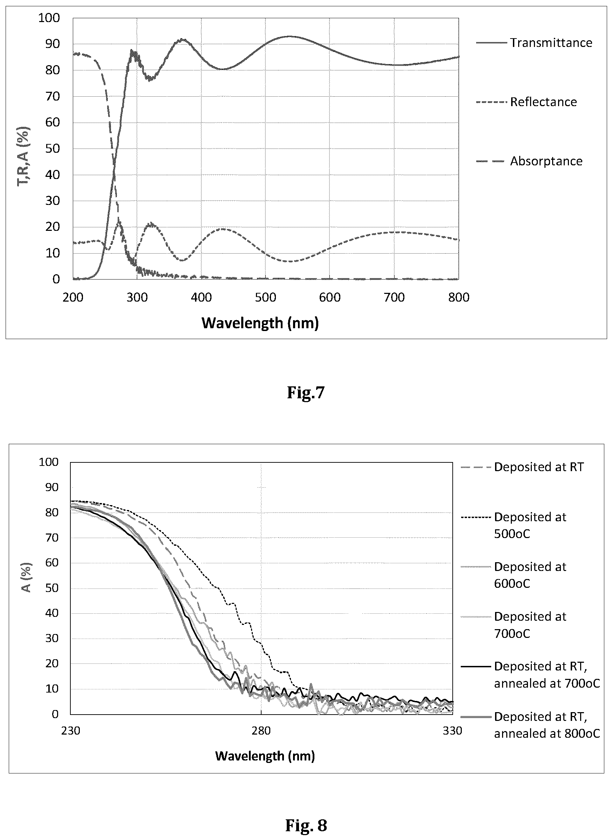

Fig. 7 - Optical Transmittance, Reflectance and Absorptance for an amorphous film of Ga₂O₃ deposited on quartz substrate at room temperature.
Fig. 8 - Optical Absorptance for films of Ga₂O₃ deposited on quartz substrates at different temperatures.

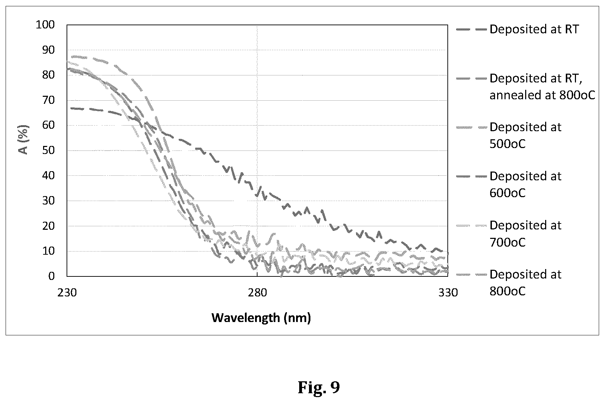

Fig. 9 - Optical Absorptance for films of Ga₂O₃ deposited on sapphire substrates at different temperatures..

### Detailed Description of the Invention

The goal of the invention is to provide a method for deposition of thin films of gallium oxide on a substrate. The set goal is reached by the proposed method for deposition of gallium oxide on a substrate inside a vacuum chamber by reactive magnetron sputtering device, wherein the method comprises the following steps: (i) placing metallic gallium pellets into a stainless steel container; (ii) heating the target container for the pellets to melt and form a uniform layer prior to mounting to the magnetron, to be the target in a liquid state during the sputtering; (iii) positioning the target in a vacuum reaction chamber having a magnetron as the source for sputtered particles; (iv) depositing a film by sputtering the metal target in argon/oxygen atmosphere; (v) locking the sputtering process into PID control mode, keeping the intensity of gallium 417.2 nm emission line constant during the deposition of the film onto the substrate.

### Examples of implementation of the invention

The target was prepared by placing metallic gallium pellets into a 15.0 x 7.5 cm box-shaped stainless steel container with 3 mm high sides. The container was heated for the pellets to melt and form a uniform layer prior to mounting to the magnetron. With the melting temperature of gallium being 29,8 degrees Celsius, the target was in a liquid state during the sputtering.

To prevent the melted metal from flowing off the magnetron surface, we have tested three different designs of target containers. With the simplest one - a stainless steel container with a flat base and vertical sides - the result was unsatisfactory, Gallium metal contracted into islands leaving large areas of the container base uncovered and exposed to sputtering.

Adopting the solution suggested in [15], the second design tested was a container with a machined recess in the base plane (Fig. 1), the recess was erosion zone shaped and wider than the actual erosion zone. Although an improvement, this still led to minor - approximately 0,5 cm² large - uncovered areas of the base of the container randomly distributed along the perimeter of the erosion zone developed during the sputtering. Finally, the container of Fig. 1 was tested with the top surface sputter-precoated by a thin layer of Ga₂O₃, SiO₂ or carbon. Since SiO₂ is electrically insulating, the electrical contact between the target container and the Gallium target was provided by a set of erosion-zone-shaped lines etched through the SiO₂ layer. While the layer of Ga₂O₃ did not lead to any improvement, the layers of Carbon and SiOz enhanced the adhesion substantially, allowing a continuous layer of gallium to form and to withstand repeated deposition cycles without exposing the container base to sputtering.

The sputtering was carried out in DC mode in argon/oxygen atmosphere at 100 to 250 W power. The same magnetron cooling system was used as for ordinary solid targets, i.e., the magnetron was cooled by 20°C water flow. The base pressure was 10⁻⁶ Torr in a turbomolecular pumped chamber. The process pressure was set at 3 mTorr by feeding 30 sccm of argon and partly closing the valve between the chamber and the pump. Quartz and c-sapphire substrates were used, with the substrate temperature varied between room (i.e., no intentional heating provided) and 800°C. Selected samples deposited at room temperature were later annealed at 800°C in air to determine whether there is a detectable difference in properties between the films heated during or after the deposition.

The process control was done by Optical Emission Spectroscopy (OES), i.e., the oxygen flow was controlled by a feedback loop keeping the intensity of gallium 417,2 nm emission line constant. An example of a typical deposition run is provided in Fig. 2. The process is started in the metal mode (argon only), the emission line intensity denoted Iₘₑₜ. Oxygen is added and the flow is increased manually to reduce the emission line intensity to the desired value. The process is locked into PID control mode, keeping the line intensity constant at the set value I_{proc}. The shutter is open, and the film is deposited onto the substrate. In this specific example, the Oxygen flow during the deposition was approximately 7.8 sccm.

For the samples deposited at room temperature, the film thickness was measured by stylus profilometer (instrument Dektak 150) and ellipsometry (instrument Woollam RC2-XI), both techniques gave similar thickness values. For the samples deposited at elevated temperatures, the thickness was determined by ellipsometry. The film structure was examined by X-ray diffraction, using Rigaku MiniFlex 600 instrument. Optical transmittance and reflectance were measured by Cary 7000 spectrophotometer.

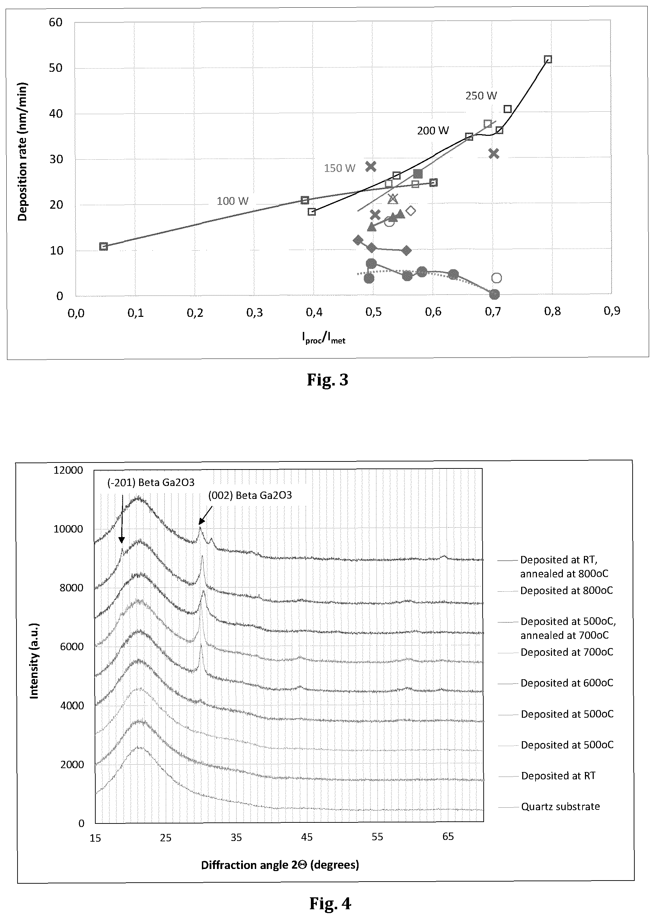

The deposition rate as a function of normalized gallium emission line intensity I_{proc}/Iₘₑₜ upon reactive sputtering from metallic gallium target at varied sputtering power and substrate temperature for films deposited on quartz and sapphire substrates is shown in Figure 3. The highest deposition rate value shown in Figure 3, approximately 51 nm/min, yielded an apparently under oxidized (optically absorbing) coating. For all other points shown in Figure 3 the coatings were highly transparent.

The main takeaways from Fig. 3 are:
(i) the deposition rate for optically transparent films - up to 41 nm/min at room temperature on quartz and 5 nm/min at 800°C on sapphire - is higher than the literature data for RF sputtering (22 and 1 nm/min, respectively). Put in a wider context, the rates for unheated substrates are relatively high compared to other materials as well. For instance, films of Zinc oxide were deposited by reactive sputtering in the same chamber with the same magnetron at the rate of 20 nm/min;
(ii) the deposition rates abate with the substrate temperature. Since the sputtering conditions are the same, the apparent reason for the lower deposition rates is a decrease in the atom sticking probability to the substrate upon higher substrate temperature. We also note that there is a deposition rate drop to virtually zero upon Iproc/Imet ratio exceeding a certain value at 800°C substrate temperature. Since the sputtering rate is expected to increase with the Iproc/Imet ratio, the drop in the deposition rate may be indicative of a minimum oxidation rate required for a film to be formed on the substrate. If the oxidation rate is below the minimum level, the arriving Gallium atoms appear to be reevaporated from the surface, thus leading to the deposition rate drop.

Described herein is process of deposition of Ga₂O₃ thin films by reactive DC magnetron sputtering form liquid Gallium metal target. The deposition rate - up to 41 nm/min at room temperature on quartz and 5 nm/min at 800°C on sapphire - is higher than the literature data for RF sputtering from ceramic targets (22 and 1 nm/min, respectively).

Amorphous and crystalline films have been deposited depending on the substrate temperature. At room to 500°C substrate temperature a feature in XRD spectrum is present that may be indicative of the presence of small size crystallites of β -Ga₂O₃ in a predominantly amorphous film. At 700°C temperature an up, β -Ga₂O₃ of single orientation was detected on sapphire, a mix of different orientations detected on quartz. The film structure dependence on the temperature is consistent with the literature data for other methods of deposition.

### References

1. M.Razeghi et al. A Review of the Growth, Doping & Applications of β-Ga203 thin films. Proc. of SPIE Vol. 10533, (2018), 105330R-1. in (SPIE)
2. Coll, M. et al. Towards Oxide Electronics: a Roadmap.Appl. Surf. Sci. 482,1-93 (2019)
3. Oshima, Y. et al. Epitaxial lateral overgrowth of α-Ga2O3 by halide vapor phase epitaxy. APL Mater. 7, 022503 (2019)
4. S.Li et al. Tunable Optical Properties of Amorphous-Like Ga2O3 Thin Films Deposited by Electron-Beam Evaporation with Varying Oxygen Partial Pressures. Nanomaterials 2020, 10, 1760
5. Pearton, S. J. et al. A review of Ga2O3 materials, processing, and devices. Appl. Phys. Rev. 5, 011301 (2018)
6. Pérez-Tomás, A. et al. Giant bulk photovoltaic effect in solar cell architectures with ultra-wide bandgap Ga2O3 transparent conducting electrodes. Mater. Today Energy 14, 100350 (2019)
7. J.Lee et al. Study of Phase Transition in MOCVD Grown Ga2O3 from κ to β Phase by Ex Situ and In Situ Annealing. Photonics 2021, 8, 17.
8. I.Donmez, C.Ozgit-Akgun, N.Biyikli. Low temperature deposition of Ga2O3 thin films using trimethylgallium and oxygen plasma. Journal of Vacuum Science & Technology A 31, 01A110 (2013)
9. Vishal Zade et al. Structural and mechanical properties of nanocrystalline Ga2 O3 films made by pulsed laser deposition onto transparent quartz substrates. 2021 Nano Ex. 2 020006
10. Y.Ohya et al. Fabrication of Ga2O3 thin films by aqueous solution deposition. Journal-Ceramic Society Japan, 2009, 117(1369):973-977.
11. K.H. Choi, H.C.Kang. Structural and optical evolution of Ga2O3/glass thin films deposited by radio frequency magnetron sputtering. Materials Letters 123 (2014) 160-164.
12. C. V. Ramana et al., Chemical bonding, optical constants, and electrical resistivity of sputter-deposited gallium oxide thin films, J. Appl. Phys. 115 (2014) 043508.
13. W.Cui et al. Optimization of Growth Temperature of β-Ga2O3 Thin Films for Solar-Blind Photodetectors. Journal of Nanoscience and Nanotechnology, Vol.18, 3613-3618, (2018)
14. S.Li et al. The influence of sputtering power on the structural, morphological and optical properties ofb-Ga2O3 thin films. Journal of Alloys and Compounds 753 (2018) 186-191
15. M.Ogita et al. Thin film for oxygen sensor at high temperature. Applied Surface Science 175-176 (2001) 721-725.
16. P.Marie, X.Portier, J.Cardin. Growth and characterization of gallium oxide thin films by radiofrequency magnetron sputtering. Physica status solidi (a), Wiley, 2008, 205 (8), pp. 1943-1946.
17. US 2015/060262 A1.

## Claims

1. A method for reactive magnetron sputtering deposition of gallium oxide thin films on a substrate inside a vacuum chamber by reactive magnetron sputtering device, wherein the method comprises the following steps:
(i) placing metallic gallium pellets into a stainless-steel container;
(ii) heating the target container for the pellets to melt and form a uniform layer prior to mounting to the magnetron, to be the target in a liquid state during the sputtering;
(iii) positioning the target onto a magnetron in a vacuum chamber to serve as the source of sputtered particles;
(iv) depositing a film by reactive sputtering in argon and oxygen atmosphere; wherein the base pressure in a chamber is preferably from 10⁻⁷ to 10⁻⁵ Torr and the process pressure preferably from 1.0 to 15.0 mTorr; the oxygen flow during the sputtering is set so as to deposit an optically transparent film; and a front surface of the target container is precoated by an adhesion-promoting layer, allowing a continuous layer of gallium to form and to withstand repeated deposition cycles without exposing the container base to sputtering; wherein the adhesion-promoting layer is a layer of SiO₂ or carbon.

2. The method according to claim 1, wherein the oxygen flow during the sputtering is controlled by plasma optical emission spectroscopy keeping the intensity of gallium 417,2 nm emission line constant.

3. The method according to claim 1, wherein the adhesion-promoting layer is a layer of Carbon.

4. The method according to claim 1, wherein the adhesion-promoting layer is a layer of SiO₂ with a set of lines etched through the layer to provide the electrical contact between the target container and the Gallium target.

5. The method according to any proceedings claims, wherein the substrate is quartz or c-sapphire with the substrate temperature selected between room temperature, without any heating provided, and 800° C.

6. The method according to any proceedings claims, wherein the deposition rate for optically transparent films is up to 41 nm/min at room temperature on quartz and 5 nm/min at 800° C on sapphire.

7. The method according to any proceedings claims, wherein the time of the deposition is selected so to achieve thickness of the deposited film in the range from 50 to 1000 nm.

## Patentansprüche

1. Verfahren zur reaktiven Magnetron-Sputterbeschichtung mit Galliumoxid-Dünnschichten auf einem Substrat innerhalb einer Vakuumkammer mittels einer reaktiven Magnetron-Sputtervorrichtung. Das Verfahren besteht dabei aus folgenden Schritten:
(i) Einbringen von metallischen Galliumkügelchen in einen Behälter aus rostfreiem Stahl;
(ii) Erhitzen des Zielbehälters, damit die Kügelchen schmelzen und eine gleichmäßige Schicht bilden, bevor sie in das Magnetron eingesetzt werden. Das Zielobjekt muss beim Sputtern in einem flüssigen Zustand sein;
(iii) Positionieren des Zielobjekts auf einem Magnetron in einer Vakuumkammer, das als Quelle für die gesputterten Partikel dienen wird;
(iv) Beschichten mit einer Dünnschicht durch reaktives Sputtern in Argon- und Sauerstoffatmosphäre, wobei der Basisdruck in einer Kammer vorzugsweise 10⁻⁷ bis 10⁻⁵ Torr und der Prozessdruck vorzugsweise 1,0 bis 15.0 m Torr beträgt, der Sauerstofffluss beim Sputtern so eingestellt ist, dass eine optisch transparente Dünnschicht abgeschieden wird und eine vordere Oberfläche des Zielbehälters mit einer haftungsfördernden Schicht vorbeschichtet ist, die es ermöglicht, dass sich eine durchgängige Schicht aus Gallium bildet und wiederholten Abscheidungszyklen widersteht, ohne dass der Behälterboden dem Sputtern ausgesetzt wird. Die haftungsfördernde Schicht ist eine Schicht aus SiOz oder Kohlenstoff.

2. Verfahren nach Patentanspruch 1, wobei der Sauerstofffluss beim Sputtern durch plasmaoptische Emissionsspektroskopie gesteuert wird. Dabei wird die Intensität der Gallium-Emissionslinie bei 417,2 nm konstant gehalten.

3. Verfahren nach Patentanspruch 1, wobei die haftungsfördernde Schicht eine Kohlenstoffschicht ist.

4. Verfahren nach Patentanspruch 1, wobei die haftungsfördernde Schicht eine SiOz-Schicht ist, durch die eine Reihe von Linien geätzt ist, um den elektrischen Kontakt zwischen dem Behälter mit dem Zielobjekt und dem Gallium-Zielobjekt herzustellen.

5. Verfahren nach einem der vorhergehenden Patentansprüche, wobei das Substrat aus Quarz oder c-Saphir besteht und die Substrattemperatur, ohne jegliche Erwärmung, zwischen Raumtemperatur und 800 °C liegt.

6. Verfahren nach einem der vorhergehenden Patentansprüche, wobei die Geschwindigkeit der Beschichtung bei optisch transparenten Schichten bei Raumtemperatur bei bis zu 41 nm/min auf Quarz und bei 5 nm/min bei 800° C auf Saphir liegt.

7. Verfahren nach einem der vorhergehenden Patentansprüche, wobei die Zeit der Beschichtung so gewählt wird, dass die Dicke der abgeschiedenen Dünnschicht im Bereich von 50 bis 1000 nm/min bei 800° C auf Saphir erreicht wird.

## Revendications

1. Procédé de dépôt par pulvérisation magnétron réactive de films minces d'oxyde de gallium sur un substrat à l'intérieur d'une chambre à vide par un dispositif de pulvérisation magnétron réactive, dans lequel le procédé comprend les étapes suivantes :
(i) mise en place de pastilles de gallium métallique dans un récipient en acier inoxydable ;
(ii) chauffage du récipient cible pour fondre les pastilles et former une couche uniforme avant montage sur le magnétron, pour être la cible dans un état liquide pendant la pulvérisation ;
(iii) positionnement de la cible sur un magnétron dans une chambre à vide pour servir de source de particules pulvérisées ;
(iv) dépôt d'un film par pulvérisation réactive dans une atmosphère d'argon et d'oxygène ; dans lequel la pression de base dans une chambre va de préférence de 10⁻⁷ à 10⁻⁵ Torr et la pression de processus va de préférence de 1,0 à 15,0 mTorr ; le débit d'oxygène pendant la pulvérisation est réglé de façon à déposer un film optiquement transparent; et une surface avant du récipient cible est prérevêtue d'une couche favorisant l'adhérence, permettant à une couche continue de gallium de se former et de supporter des cycles de dépôt répétés sans exposer la base de récipient à une pulvérisation ; dans lequel la couche favorisant l'adhérence est une couche de SiO₂ ou de carbone.

2. Procédé selon la revendication 1, dans lequel le débit d'oxygène pendant la pulvérisation est commandé par spectroscopie d'émission optique à plasma en gardant l'intensité de la ligne d'émission à 417,2 nm du gallium constante.

3. Procédé selon la revendication 1, dans lequel la couche favorisant l'adhérence est une couche de carbone.

4. Procédé selon la revendication 1, dans lequel la couche favorisant l'adhérence est une couche de SiO₂ avec un ensemble de lignes gravées à travers la couche pour fournir le contact électrique entre le récipient cible et la cible de gallium.

5. Procédé selon l'une quelconque revendication précédente, dans lequel le substrat est du quartz ou du c-saphir, avec la température de substrat sélectionnée entre la température ambiante, sans aucun chauffage fourni, et 800 °C.

6. Procédé selon l'une quelconque des revendications précédentes, dans lequel la vitesse de dépôt pour des films optiquement transparents va jusqu'à 41 nm/min à la température ambiante sur du quartz et 5 nm/min à 800°C sur du saphir.

7. Procédé selon l'une quelconque des revendications précédentes, dans lequel le temps du dépôt est sélectionné de façon à obtenir une épaisseur du film déposé dans la plage allant de 50 à 1000 nm.
